Europäisches Patentamt

European Patent Office

Office européen des brevets

(19)

(11) Publication number : **0 457 390 B1**

# (12) EUROPEAN PATENT SPECIFICATION

(45) Date of publication of patent specification :
**11.01.95 Bulletin 95/02**

(51) Int. Cl.⁶ : **H04B 1/66**

(21) Application number : **91201087.3**

(22) Date of filing : **07.05.91**

(54) Encoding system comprising a subband coder, and a transmitter comprising an encoding system.

(30) Priority : **14.05.90 NL 9001127**

(43) Date of publication of application :
**21.11.91 Bulletin 91/47**

(45) Publication of the grant of the patent :
**11.01.95 Bulletin 95/02**

(84) Designated Contracting States :
**AT BE DE FR GB IT NL**

(56) References cited :
PHILIPS JOURNAL OF RESEARCH, vol. 44,
nos. 2/3, 28th July 1989, pages 329-343,Eindho-
ven, NL; R.N.J. VELDHUIS et al.: "Subband
coding of digital audiosignals"
1989 INTERNATIONAL CONFERENCE ON
ACOUSTICS, SPEECH, AND SIGNAL PROCES-
SING,Glasgow, 23rd - 26th May 1989, vol. 3,
pages 2009-2012, New York, US; R.N.J.VEL-
DHUIS et al.: "Subband coding of digital audio
signals without loss of quality"

(73) Proprietor : **Philips Electronics N.V.**
**Groenewoudseweg 1**
**NL-5621 BA Eindhoven (NL)**

(72) Inventor : **Veldhuis, Raymond Nicolaas Johan**
**c/o INT. OCTROOIBUREAU B.V.,**
**Prof. Holstlaan 6**
**NL-5656 AA Eindhoven (NL)**
Inventor : **Keesman, Gerrit Johan**
**c/o INT. OCTROOIBUREAU B.V.,**
**Prof. Holstlaan 6**
**NL-5656 AA Eindhoven (NL)**

(74) Representative : **van der Kruk, Willem**
**Leonardus et al**
**INTERNATIONAAL OCTROOIBUREAU B.V.,**
**Prof. Holstlaan 6**
**NL-5656 AA Eindhoven (NL)**

## Description

The invention relates to an encoding system, comprising a subband coder for subband coding of a wideband digital signal, for example, a digital audio signal, at a specific sampling frequency $F_s$, the subband coder including signal splitting means for generating, in response to the wideband digital signal, a plurality of P subband signals with sampling frequency reduction, for which purpose the splitting means split up the wideband digital signal into successive subbands which augment with frequency, which encoding system further comprises quantizing means for quantizing block-by-block the respective subband signals, a quantized subband signal m being composed of successive signal blocks, each signal block comprising q samples, the q samples in a signal block of the subband signal m being represented each by $n_m$ bits, the quantizing means including bit need determining means for determining a bit need $b_m$ per signal block for corresponding signal blocks in the subband signals, which bit need is related to the number of bits by which samples in a signal block in the subband signal m should be represented, and the quantizing means including a bit allocation means for allocating an available quantity of bits B to the corresponding signal blocks of the various subband signals in response to the bit need determined by the bit need determining means so as to obtain the values $n_m$, where m ranges from 1 to P, and which encoding system further comprises accommodating means for accommodating the samples quantized with a certain number of bits in a signal block in a frame of a second digital signal having successive frames, the accommodating means further being arranged for accommodating the scale factor information in a frame, which scale factor information comprises x-bit words, an x-bit word representing a scale factor associated to the samples in a signal block, and the invention further relates to a transmitter comprising the encoding system.

## BACKGROUND OF THE INVENTION

The encoding system of the type mentioned in the preamble is known from European Patent Application No. 289.080, prior-art document (1) in the list of documents stated at the end of the descriptions of the drawing Figures.

Subband encoding of a single signal, such as a mono audio signal or a left or right signal portion of a stereo signal, may be concerned here. In that case P equals M. In each subband the splitting means then generate one subband signal. However, this may also relate to a stereo signal which is to be subband encoded. In that ease it holds that P equals 2M. The subband splitting means then generate two subband signals in each subband, i.e. a left and a right subband signal.

## SUMMARY OF THE INVENTION

The invention specifically relates to the bit allocation means allocating the bits to the various signal blocks on the basis of the bit needs $b_1$ to $b_P$ for corresponding signal blocks in the subbands $SB_1$ to $SB_M$ and on the basis of a certain initial number of bits B to be allocated. The number of bits used in each subband for quantizing the samples in the signal blocks is to be variable with time in order to realise a highest possible perceptual quality.

The invention provides a method of allocating the available bits to the quantizers according to a specific criterion.

For this purpose, the encoding system according to the invention is characterized in that on the basis of the bit needs, for corresponding signal blocks in the subband signals in the subbands determined in the bit need determining means, the bit allocation means is arranged for the following operations in a specific step $S_1$:

(a) determining $b_j$, which is the largest of the bit needs,

(b) establishing whether bits have previously been allocated to the signal block belonging to the bit need $b_j$, and if they have not, then

(c)
- allocating a value $a_1$ to $n_j$;
- subtracting a value $a_2$ from $b_j$;
- subtracting the value $a_1.q+x$ from B,

and if they have, then

(d)
- adding the value $c_1$ to $n_j$;
- subtracting the value $c_2$ from $b_j$;
- subtracting the value $c_1.q$ from B,

and for performing the step $S_1$ at least a second time, in that q and x are integers greater than unity, in that $n_m$ and $b_m$ are variables where $n_m$ is greater than or equal to zero, $a_1$, $a_2$, $c_1$ and $c_2$ are numbers greater than zero and B is an integer greater than zero, m is a variable integer, $a_1$ is greater than $c_1$ and $a_2$ is greater than or equal to $c_2$.

From prior-art document (4) a method is known which is very similar to the method proposed in this application, compare especially, chapter 4.2 "Adaptive bit allocation" in this document. However, after the maximum bit need $b_j$ is determined, the value $n_j$ is raised by unity in all cases. Contrary to this known method, a distinction is made according to the invention for the situation in which bits are allocated for the first time to a signal block j ($n_j=0$). In that case $n_j$ is assumed to be equal to $a_1$, whereas if bits have already been allocated to the signal block j at an earlier instant ($n_j>0$), $n_j$ is raised by $c_1$, where $a_1>c_1$. For example, $a_1$ is equal to 2 and $c_1$, for example, is equal to 1. In a first bit allocation to a signal block, more bits are allocated to each sample than with a second or subsequent bit allocation.

Research has shown that a bit allocation as proposed by the present invention leads to a better encoding of the digital signal, so that the reconstructed digital signal has a better quality after decoding.

The encoding system may further be characterized in that the bit allocation means is arranged for carrying out the following operations in a step $S_0$ prior to the steps $S_1$, for a signal block k in a subband:

- allocating a value $A_{k0}$ to $n_k$;
- subtracting the value $A_{k1}$ from $b_k$;
- subtracting the value $A_{k0}.q+x$ from B, and in that $A_{k0}$ and $A_{k1}$ are numbers greater than zero.

In this step, preceding the steps $S_1$, bits are allocated to signal blocks in subbands which are not to be quantized by zero bits whatever their bit need. The reason for this is that sometimes subbands cannot readily be switched off. This could then produce audible effects.

The encoding system may further be characterized in that the bit allocation means is arranged for allocating a flag value in the step $S_0$ to a signal block in one or more subbands, which flag value indicates that no bits are to be allocated to the signal block concerned. In this respect it thus holds that some subbands must not be switched on also because this could produce audible effects.

## BRIEF DESCRIPTION OF THE DRAWINGS

The invention will be further explained in the following descriptions with reference to a number of exemplary embodiments, in which:

Fig. 1 shows an encoding system according to the invention;

Fig. 1a shows the corresponding signal blocks in the subband signals $SB_1$ to $SB_M$, each signal block comprising q samples;

Fig. 2 shows the quantization to a three-bit binary representation;

Fig. 3 shows the positions of the bit needs $b_1$, $b_2$, ..., along the value axis;

Fig. 4 shows the method of determining the bit needs $b_1$, ..., $b_P$;

Fig. 5 shows the method of allocating bits to the signal blocks in the subbands;

Fig. 6 shows the initial bit allocation;

Fig. 7 shows the correction Table to be used for number additions utilizing a logarithmic representation of the numbers;

Fig. 8 shows a hardware design of the bit need determining means;

Fig. 9 shows a hardware design of the bit allocation means;

Fig. 10 shows the use in a transmitter in the form of a recording arrangement for recording quantized subband signals on a magnetic record carrier;

Figs. 11, 12 and 13 show the different allocation stages in dependence on the power value $v_i$, and

Fig. 14 shows a diagram of the unit for generating the control signals featuring the different allocation stages.

## DESCRIPTION OF (PREFERRED) EMBODIMENTS

The description of the drawings will in essence relate to the description of the subband encoding of a single digital signal. That is to say, the subband encoding of a mono audio signal, or the subband encoding of only the right or rather the left signal portion of a stereo audio signal. As already observed above, this implies that P equals M and that in each subband signal there is only one subband signal present.

At the end of this description it will be explained how the bit need may be determined in case of subband encoding of a stereo signal, it being understood that P equals 2M. There are two subband signals in each subband.

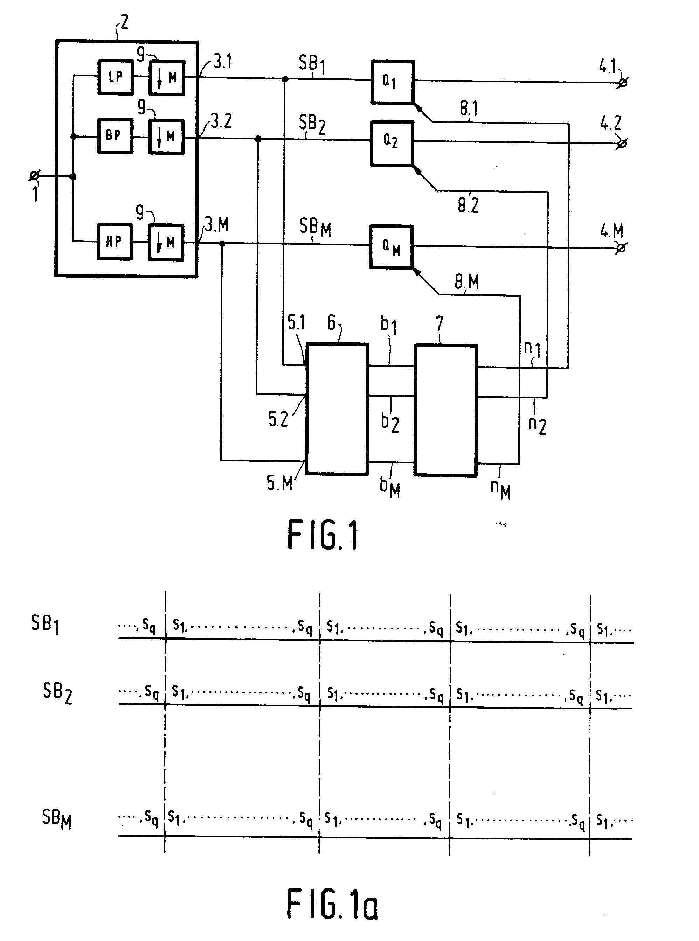

Fig. 1 shows the encoding system according to the invention. A wideband digital signal is applied to input terminal 1. An audio signal having a bandwidth of approximately 20 kHz may be considered in this respect.

Input 1 receives, for example, 16-bit samples of the audio signal at a sampling frequency of 44 kHz. The audio signal is applied to a subband coder 2 which comprises signal splitting means. The subband coder 2 distributes the audio signal over M subbands by means of M filters, that is to say, a low-pass filter LP, M-2 band-pass filters BP and a high-pass filter HP. M is, for example, equal to 32. The sampling frequency of the M subband signals is reduced in the blocks referenced 9. In these blocks the sampling frequency is reduced by a factor M. The signals thus obtained are available at the outputs 3.1, 3.2, ..., 3.M. At the output 3.1 the signal is available in the lowest subband $SB_1$. At the output 3.2 the signal is available in the lowest but one subband $SB_2$. At the output 3.M the signal is available in the highest subband $SB_M$. The signals at the outputs 3.1 to 3.M have the structure of successive samples expressed in numbers of 16 bits or over, for example 24. In the exemplary embodiment of the invention under discussion the subbands $SB_1$ to $SB_M$ all have the same width. This is not a necessity, however.

In the prior-art publication (5), by Krasner, a subdivision into a plurality of subbands is provided whose bandwidths approximately correspond to the bandwidths of the critical bands of the human auditory system in the respective frequency areas. The operation of the subband coder 2 will not further be explained since the operation of a subband coder has already been described extensively hereinbefore. For this purpose, reference is made to the prior-art documents (1), (5) and (7) which are assumed to be incorporated in this application where necessary.

The subband signals are combined to successive signal blocks of q successive samples, cf. Fig. 1a, and are applied to corresponding quantizers $Q_1$ to $Q_M$. In a quantizer $Q_m$ the samples are quantized to quantized samples having a number of bits $n_m$ smaller than 16.

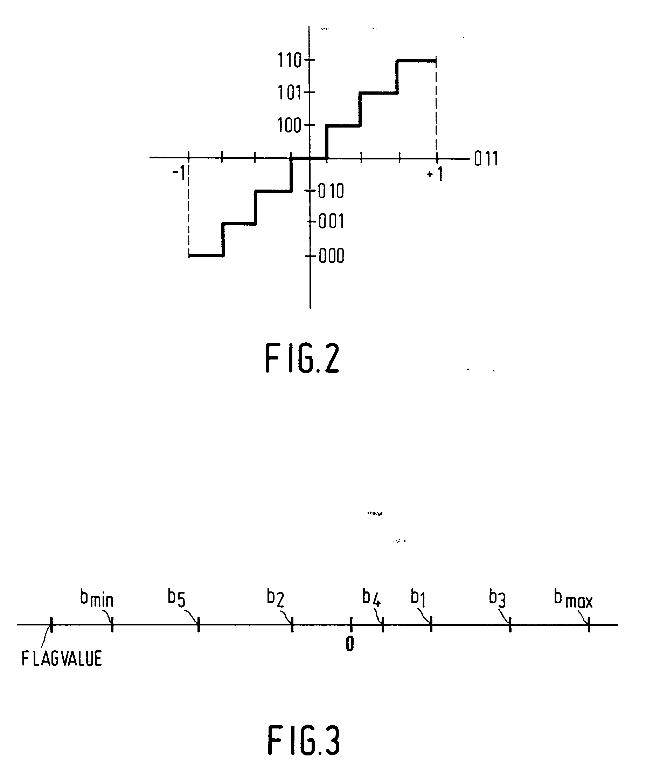

Fig. 2 shows a quantization with a 3-bit binary representation. During the process of quantization the signal blocks (groups) of q successive samples of the subband signals are each time quantized with a number of bits (3) in the example of Fig. 2. For example, q is equal to 12. In addition, the q samples in a signal block are normalized first. This normalization is performed by dividing the amplitudes of the q samples by the amplitude of the sample having the largest absolute value in the signal block. The amplitude of the sample having the largest amplitude in the signal block of subband $SB_m$ yields the scale factor $SF_m$, cf. documents (2a), (2b). Subsequently, the amplitudes of the normalized samples, which are now situated in an amplitude range from -1 to +1, are quantized according to Fig. 2.

This implies that samples in the amplitude range between -1 and -0.71 are quantized with the 3-bit number 000,
samples in the amplitude range from -0.71 to 0.42 are quantized with 001,
samples in the amplitude range from 0.42 to 0.14 are quantized with 010,
samples in the amplitude range from -0.14 to 0.14 are quantized with 001,
samples in the amplitude range from 0.14 to 0.42 are quantized with 100,
samples in the amplitude range from 0.42 to 0.71 are quantized with 101 and
samples in the amplitude range from 0.71 to 1.00 are quantized with 110.

In the prior-art document (2b) this three-bit quantization is extensively discussed, cf. Figs. 24, 25 and 26 and the relevant descriptions in that document.

The quantized samples in the subbands $SB_1$ to $SB_M$ are thereafter available at the respective outputs 4.1 to 4.M.

Furthermore, the outputs 3.1 to 3.M are coupled to the respective inputs 5.1 to 5.M of bit need determining means 6. The bit need determining means 6 determine the bit need $b_m$ for the time equivalent signal blocks of q samples in the subbands $SB_1$ to $SB_M$. The bit need $b_m$ is a number related to the number of bits with which the q samples in a q-sample signal block in a subband signal should be quantized.

The bit needs $b_1$ to $b_M$, derived by the bit need determining means 6, are applied to bit allocation means 7. The bit allocation means 7 determines the actual number of bits $n_1$ to $n_M$ with which the q samples of the corresponding signal blocks in the subband sig-

nals $SB_1$ to $SB_M$ are quantized. Control signals corresponding to the numbers $n_1$ to $n_M$ are applied to the respective quantizers $Q_1$ to $Q_M$ through lines 8.1 to 8.M, so that the quantizers can quantize the samples with the correct number of bits.

The following will provide an explanation of the operation of the bit need determining means 6 and the bit allocation means 7. The bit needs for the time-equivalent signal blocks of q samples in the subband signals $SB_1$ to $SB_M$ are derived from estimates for the power $v_m$ and the scale factor $SF_m$ in a signal block in a subband signal $SB_m$.

The power $v_m$ may, for example, be obtained by means of the following formula:

$$v_m = \frac{1}{q} \sum_{i=1}^{q} s_i^2$$

where $s_i$ is the amplitude of the $i^{th}$ sample in the q-sample signal block in the subband $SB_m$. The scale factor $SF_m$ was equal to the amplitude of the sample in the signal block having the largest absolute value, as has already been observed hereinbefore.

It should be observed in this context that the estimate for the power $v_m$ in a signal block in the subband $SB_m$ also might have been obtained by assuming that $v_m$ was equal to the squared scale factor $SF_m$.

For all corresponding signal blocks in the subband signals $SB_1$ to $SB_M$ the power $v_m$ and the scale factor $SF_m$ are determined in this fashion. The powers are ordered in a vector {v}. By multiplying the vector {v} by an M x M matrix [D], one will obtain a vector {w} utilizing the following formula:

$$\{w\} = [D]\{v\} + \{w_r\}$$

In this formula [D] is a matrix whose coefficients $d_{ij}$ denote the coefficient by which the power $v_j$ of the q-sample signal block in the subband signal $SB_j$ is to be multiplied to calculate the masked power in the subband $SB_i$ due to the signal in the q-sample signal block in the subband signal $SB_j$ and $w_{r,i}$ is the coefficient in the vector {$w_r$} which denotes the masking threshold in the subband $SB_i$. Thus, $w_{r,m}$ bears a relation to the maximum signal power of the signal in a subband $SB_m$ which signal is not audible.

The vector {w} now has the coefficients $w_i$ which are estimates for the masked quantizing noise in each subband $SB_i$. Quantizing-noise in subband $SB_i$ which has a power of less than $w_i$, is thus inaudible. The coefficients $d_{ij}$ of the matrix [D] are to be calculated according to the literature, cf. prior-art document (4). The bit need $b_1$ to $b_M$ can be calculated with the aid of the following formula:

$$b_m = K_1 \cdot 2\log\left(\sqrt{SF^2_m/3w_m} + 1\right)$$

or more generally:

$$b_m = K_1 \cdot 2\log\left(K_2\sqrt{SF^2_m/w_m} + K_3\right)$$

The former formula can simply be derived from the latter formula by assuming: $K_2 = 1/\sqrt{3}$ and $K_3 = 1$. $K_1$, $K_2$ and $K_3$ are constants, for which it holds that $K_1$ is preferably equal to approximately 1 and $K_2$ is preferably equal to approximately $1\sqrt{3}$. $K_3$ has a wider range of possibilities. It may be assumed that $K_3$ will be less than 10, where $K_3$ will, for example, preferably be taken to be equal to 1 or may be neglected. In addition, in the latter case there will be a simpler implementation of the calculation.

The coefficients (bit needs) $b_1$ to $b_M$ obtained in this fashion, are situated in a specific amplitude range. The coefficients may be negative and non-integers. A coefficient $b_m$ bears a relation to the number of bits with which the samples in the q-sample signal block of a subband signal $SB_m$ should be quantized, so that it holds that if $b_{m1}$ for subband signal $SB_{m1}$ is greater than $b_{m2}$ for the subband signal $SB_{m2}$, the number of bits with which the q samples in a signal block in the subband signal $SB_{m1}$ should be quantized will have to be greater than the number of bits with which the q samples of a time-equivalent signal block in the subband signal $SB_{m2}$ should be quantized.

This is shown in qualitative terms with reference to Fig. 3. In Fig. 3 seven bit needs $b_1$ to $b_5$, $b_{max}$ and $b_{min}$ are plotted along the value axis. $b_{max}$ is the bit need having the maximum value and $b_{min}$ is the bit need having the minimum value. It will be noticed that $b_{min}$, $b_2$ and $b_5$ are negative and that, furthermore, the following holds: $b_{min} < b_5 < b_2 < b_4 < b_1 < b_3 < b_{max}$. In terms of quality it may now be assumed that the subband signal $SB_m$, with $b_m = B_{min}$, should/could be quantized with the minimum number of bits and the subband signal $SB_m$, with $b_m = b_{max}$, with the maximum number of bits.

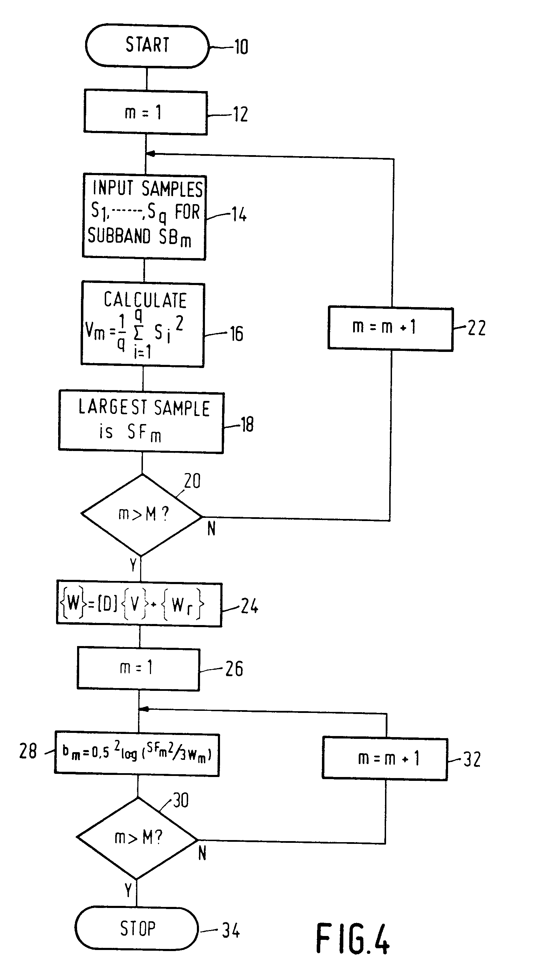

Fig. 4 shows a flow chart of the operation of the bit need determining means 6.

Fig. 4 shows the program for determining the bit needs $b_1$ to $b_M$ for time-equivalent q-sample signal blocks in the subband signals $SB_1$ to $SB_M$. In this case only a single q-sample signal block in a subband signal is concerned. For a successive q-sample signal block in the subband signal, and the signal blocks of the other subband signals corresponding with the signal block (in case of a time-parallel subband signal supply), the operation represented in Fig. 4 will be performed once again.

The operation starts at block 10. First, the running variable m is set to 1 (block 12). Then, the q samples $S_1$, ..., $S_q$ of a signal block in a subband signal $SB_m$ are inputted (block 14) and the power $V_m$ is calculated (block 16). Also the scale factor $SF_m$ (block 18) is determined.

The blocks 14, 16 and 18 are repeated for all subband signals via the loop through blocks 20 and 22. If the values $V_m$ and $SF_m$ have been determined for all corresponding signal blocks, the matrix calculation will be performed in order to obtain the vector {w} (block 24).

Subsequently, m is again set to 1 (block 26) and the bit need ($b_m$) is determined (block 28) for all subbands via the loop through the blocks 30 and 32 after which the operation is terminated (block 34). The bit needs $b_m$ are determined in block 28 according to the formula given hereinbefore, while the constants $K_1$, $K_2$ and $K_3$ have become equal to 1, $1\sqrt{3}$ and 0 respectively.

The method of Fig. 4 shows the time-consecutive calculations of the coefficients $v_m$ in the vector {v}, compare the loop through block 22 in the program, and the method shows the time-consecutive calculations of the bit needs $b_1$ to $b_M$, compare the loop through block 32. This is a very suitable method, more specifically, if the corresponding signal blocks having the samples $S_1$ to $S_q$ for the successive subbands $SB_1$, $SB_2$, ..., $SB_{M-1}$, $SB_M$, are applied serially.

If the signal blocks are applied in parallel, the calculation of the coefficients $v_m$ could be performed in parallel for all subbands and thus the loop through block 22 is avoided. Likewise, the bit needs $b_1$ to $b_M$ may be calculated in parallel and this will render the loop through block 32 redundant.

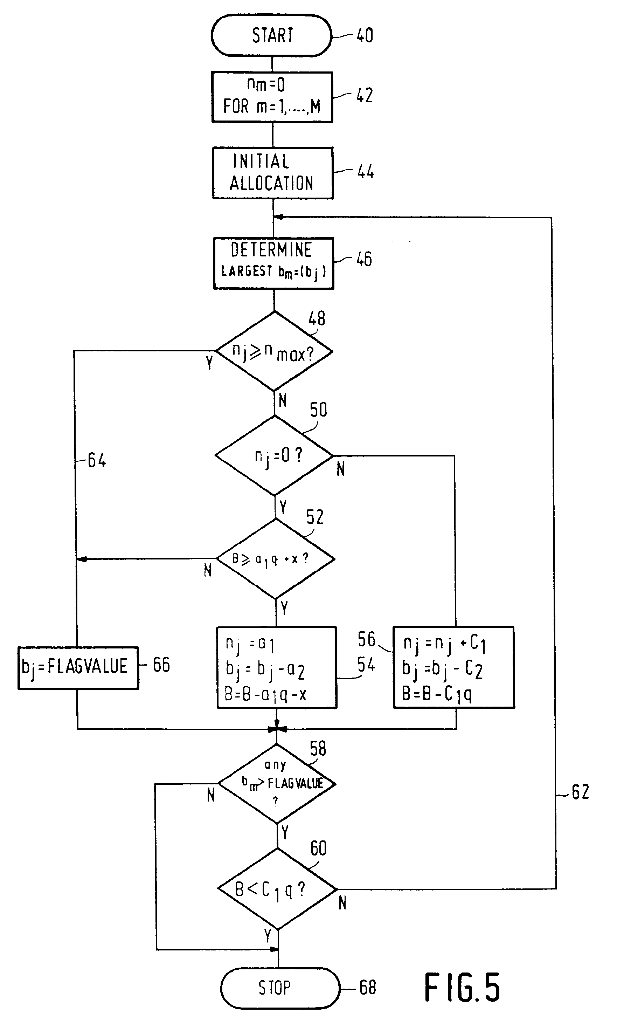

The operation of the bit allocation means 7 will now be explained. The flow chart of Fig. 5 will be used for this purpose. The program determines for time-equivalent q-sample signal blocks in the subband signals $SB_1$ to $SB_M$ the values $n_1$ to $n_M$ from the bit needs $b_1$ to $B_M$. Here too it is a matter of a single signal block having q samples in a subband signal. For a directly successive q-sample signal block in the subband signal and the time-equivalent signal blocks in the other subband signals, the method of Fig. 5 will be carried out again.

It is now assumed that, after quantization, $B_0$ bits are available for transmitting the overall information connected with the M signal blocks of q samples of, for example, 24 bits each. Assuming that after quantization, R bits are available per sample, averaged over the subbands, it holds that $B_0$ is equal to the largest integer smaller than M.q.R.

In the prior-art documents (2a) and (2b) it is shown that not only the quantized samples are transmitted, but also the scale factors $SF_1$ to $SF_M$ (scale factor information) and the bit allocation information (that is to say, information which bears a relation to the number of bits with which the samples in a signal block in a subband signal are quantized i.e. the values $n_1$ to $n_M$). The bit allocation information is then represented by y=4 bits for each $n_m$. Thus, this implies that, actually, only $B = B_0 - y.M$ bits are available for the transmission of M signal blocks of quantized subband signals and the scale factor information.

The documents (2a) and (2b) further describe that the y-bit number (y=4) 0000 in the bit allocation information denotes that no samples are transmitted in the relevant subband. In that case no scale factor information for this subband will be transmitted either. The scale factor information for a subband is represented by means of an x-bit number (x=6).

The method of bit allocation is now as follows. The method starts at block 40, Fig. 5. Subsequently, all numbers $n_m$ are first set to zero. Then an initial bit allocation is performed at block 44. This initial bit allocation will be explained in the following with reference to Fig. 5. Thereafter, the maximum bit need is determined. This is the bit need $b_j$. In the example of Fig. 3 this would be $b_{max}$. Then it is considered whether $n_j$ is greater than or equal to a certain value $n_{max}$ (block 48). In the present example $n_{max}$ is equal to 16. This means that the quantized samples can only be represented by binary numbers with a maximum of 16 bits.

If $n_j$ is greater than or equal to $n_{max}$, the q-sample signal block in the subband j will be excluded from the allocation of further bits. For this purpose, the bit need $b_j$ is made equal to a so-called "flag value" (block 66). The flag value is represented in Fig. 3 and is a value smaller than the minimum bit need $b_{min}$. If $c_1$ in the block 56 to be discussed hereinbelow is greater than unity, $n_j$ might be greater than $n_{max}$. In addition, $n_j$ will then be assumed to be equal to $n_{max}$ at block 66.

If $n_j$ is equal to zero (block 50), the program will proceed through the blocks 52 and 54. At block 54, $a_1$ bits are initially allocated to the subband $SB_j$. This means $n_j = a_1$. The total number B of available bits now decreases by $a_1.q+x$. The q quantized samples of the signal block in the subband signal $SB_j$ are represented each by $a_1$ bits and, in addition, an x-bit-long scale factor $SF_j$ is to be added. Furthermore, in block 54 the bit need $b_j$ is decreased by a value $a_2$. If $n_j$ is unequal to zero, the program will proceed through block 56. The number of bits $n_j$ is now increased by $c_1$. The total number B of available bits now decreases by $c_1.q$, due to the fact that the q quantized samples of a signal block are now represented by an additional number of $c_1$ bits.

Naturally, bit allocation only takes place if there are still sufficient bits available. Therefore, block 52 is present. Because, if there are insufficient bits available the program will proceed through block 66 at which the relevant bit need $b_j$ is again made equal to the flag value. The signal block in the subband concerned is then excluded from further bit allocation.

As long as there are bit needs that have values greater than the flag value (block 58) and as long as there are still sufficient bits available (block 60), the program will return through circuit 62 to block 46 for a next calculation of the maximum bit need. If all bit needs $b_m$ are smaller than or equal to the flag value, the program will stop. The program will also stop if there are insufficient bits to be allocated (block 60).

The method is characterised in that when a first bit allocation is performed (block 54), the number of allocated bits ($a_1$) is greater than the number of bits of one or more subsequent allocations (block 56) ($c_1$), worded differently $a_1>c_1$. Furthermore, it holds that $a_2$ is greater than or equal to unity. Preferably, $a_1$ is equal to $a_2$ and $c_1$ equal to $c_2$. $a_1$, $a_2$, $c_1$ and $c_2$ are numbers greater than zero. $a_1$ and $c_1$ are preferably integers. But, this is not a necessity. An example may be shown for this purpose.

It is assumed that one wishes to quantize the q samples in a signal block in five levels. For this purpose, 3 bits are needed per sample. However, this is not an efficient encoding because a subdivision into seven levels of 3 bits is possible.

If, however, three samples are combined, these three samples with five signal level will present 125 options. These 125 options may be represented by means of a 7-bit binary number. Thus, no more than 7/3 bits per sample. $n_m$ would in that case be equal to 7/3. This will provide a more efficient encoding.

It has been indicated hereinbefore that when the quantized samples are transmitted, both scale factor information and bit allocation information are co-transmitted. The scale factor information then has the form of x-bit words, of which each x-bit word denotes a scale factor $SF_m$ that belongs to the q samples in a signal block in the subband $SB_m$. The bit allocation information then has the form of y-bit words, of which each y-bit word denotes a number of bits $n_m$ by which each sample in a signal block in the subband $SB_m$ is represented. Previously, the prior-art documents (2a) and (2b) have already been referred to.

If in the bit need determining means 6 only the scale factors $SF_m$ are used for calculating the powers $v_m$, that is to say, because $v_m$ is assumed to be equal to the square of $SF_m$, the bit allocation information need not be co-transmitted.

On the receiver side the bit needs $b_1$ to $b_M$ can be derived from the transmitted scale factors $SF_m$ and on the basis of these needs the magnitudes $n_1$ to $n_M$, while implementing the calculation method as discussed hereinbefore. Thus, the receiver likewise comprises bit need determining means which derive the powers $v_m$ from the scale factors $SF_m$ and derive from these powers the bit needs $b_m$, and also includes bit allocation means which is capable of calculating the magnitudes $n_1$ to $n_M$ on the basis of the bit needs $b_m$ and the available bit quantity which in this case is equal to $B_0$. Since, as observed hereinbefore, $B=B_0-y.M$, the latter method is advantageous in that more bits can be allocated to the subbands.

It may sometimes be necessary to pre-allocate a number of bits to a signal block in a subband $SB_m$, for example, in the case where there are signal blocks which must not be quantized with zero bits irrespective of their bit need. The reason for this is that signal blocks must not be switched on or off in an unqualified manner. This would produce audible effects.

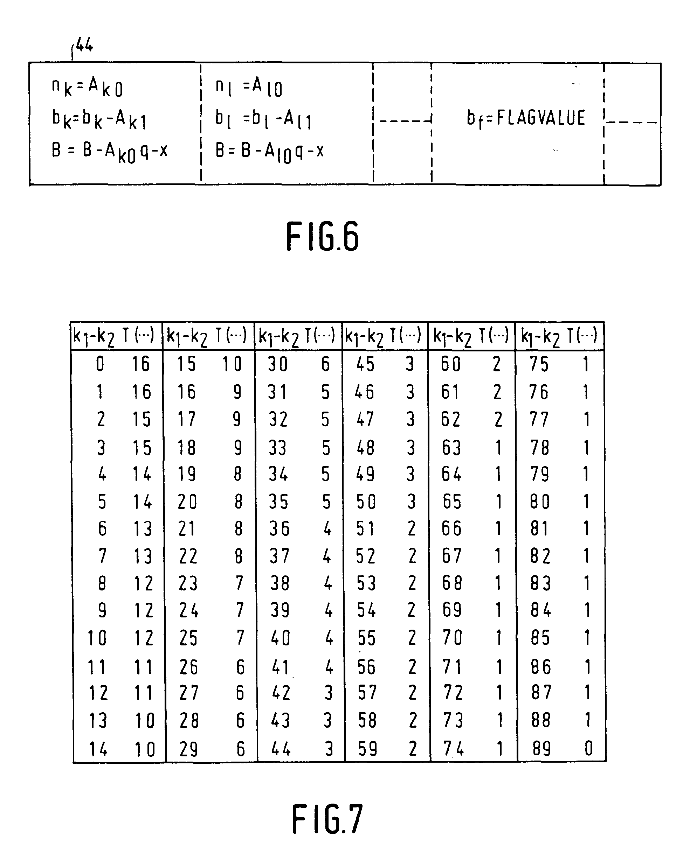

The above also shows that it may sometimes be necessary or useful to exclude a signal block in advance from bit allocation. For this purpose, block 44 in the program of Fig. 5 is inserted. Fig. 6 shows an elaboration of block 44. Two signal blocks are represented there, that is to say, the signal blocks in the subbands $SB_k$ and $SB_1$ to which have been pre-allocated a number of bits $A_{k0}$ or $A_{10}$. This implies that $n_k = A_{k0}$ and $n_1 = A_{10}$. From the bit needs $b_k$ and $b_1$ the respective values $A_{k1}$ and $A_{11}$, are subtracted and the remaining number of bits B is reduced by $A_{k0}.q\text{-}x$ and $A_{10}.q\text{-}x$ respectively. Actually, for $A_{k0}$ and $A_{10}$ the same holds as for $a_1$. Preferably, $A_{k0} = A_{10} = a_1$. For $A_{k1}$ and $A_{11}$ the same holds as for $a_2$. Preferably, $A_{k1} = A_{11} = a_2$.

To the signal blocks in the subbands $SB_k$ and $SB_1$ may naturally be allocated more bits, as required, at block 56 of the method presented in Fig. 5.

Furthermore, at block 44 of Fig. 6 it is shown that the signal block in the subband $SB_f$ is excluded from bit allocation. For this purpose, the bit need $b_f$ for this signal block is made equal to the flag value.

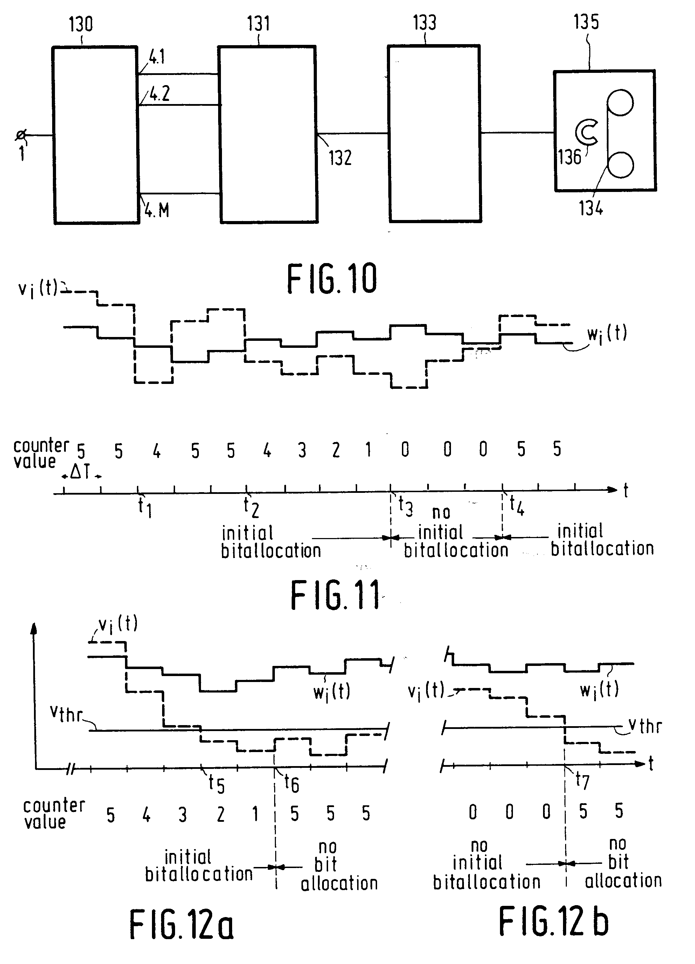

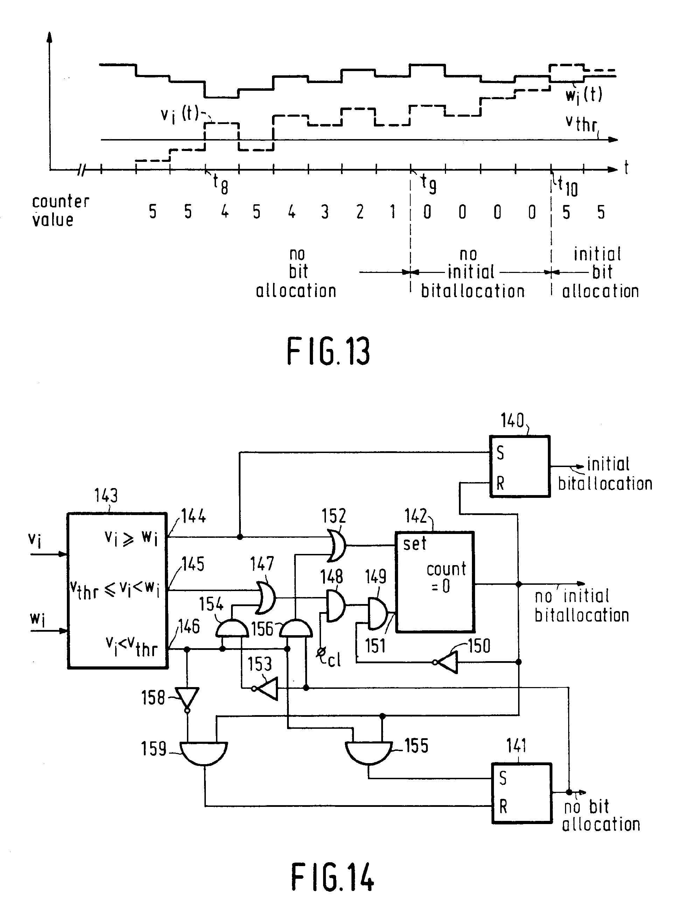

Figs. 11, 12 and 13 represent the situations in which there is initial bit allocation or no initial bit allocation to the subbands. The Figures show the consecutive time intervals $\Delta T$ in which a group of M corresponding signal blocks of the M subbands are processed. In each time interval the power $v_i(t)$ and the magnitude $w_i(t)$ are determined for each subband $SB_i$. If $V_i(t)$ is greater than $w_i(t)$, there will be initial bit allocation to the subband $SB_i$. As will be evident from Fig. 11, this holds for periods of time situated before $t=t_1$. Fig. 14 shows a circuit by means of which, on the basis of the magnitudes $v_i$ and $w_i$, control signals may be derived which denote whether initial bit allocation is to take place, in which case the output of the SR flip-flop 140 is "high" or "logic 1", or whether no bit allocation is to take place, in which case the output of the SR flip-flop 141 is "high", or whether no initial bit allocation takes place, in which case the output of a counter 142 is "high". In the latter case bits may still be allocated to the subband in question, but the allocation then takes place at block 54 and may also take place at block 56 according to the method of Fig. 5. These control signals may thus be applied to block 44 in Fig. 6 and denote what functions are to be performed in this block.

At the instant $t=t_1$, $V_i(t)$ becomes smaller than $w_i(t)$ The output 144 of the comparator 143 now becomes "low" whereas the output 145 of this comparator becomes "high". Through the OR-gate 147 this "high" signal is applied to the AND-gate 148 so that clock pulses are passed to the AND-gate 149 at a rate f equal to $1/\Delta T$. Since a "high" signal is applied to the other input of the AND-gate 149 through the inverter 150, the clock pulses are passed to the input 151. The counter 142 now counts down from the initial position 5 (decimal) under the influence of the clock pulses, cf. Fig. 11. Since the output of the counter 142 remains "low", the position of the flip-flop 140 does not change so that the initial bit allocation is maintained.

One time interval later, $v_i(t)$ is again larger than $w_i(t)$. The output 144 of the comparator 143 becomes "high" again which implies that the rising edge is fed to the set input of the counter 142 through the OR-gate 152. The count of counter 142 is reset to 5 (decimal). At the instant $t_2$, cf. Fig. 11, $v_i(t)$ again becomes smaller than $w_i(t)$. Now, $v_i(t)$ remains smaller than $w_i(t)$ for a sufficiently long period of time to make it possible for the counter 142 to count back until the 0 count (decimal) is reached. This is reached at the instant $t=t_3$, cf. Fig. 11. At that moment the output of the counter 142 becomes "high". The flip-flop 140 is reset. Through inverter 150 and AND-gate 149 the counting operation of counter 142 is blocked so that it retains the 0 count.

Initial bits are no longer allocated to this subband. At the instant $t=t_4$, $V_i(t)$ again becomes larger than $w_i(t)$ The counter 142 is reset to the count 5 and, in addition, the flip-flop 140 is set in a manner so that initial bits are again allocated.

Fig. 12a represents a situation in which $v_i(t)$, prior to the instant at which the counter 142 is reset to zero, already becomes smaller than a specific threshold value $v_{thr}$. At the instant $t=t_5$ the output 145 of the comparator 143 becomes "low" again and the output 146 "high". Since the inverter 153 applies a "high" signal to one input of the AND-gate 154, the "high" signal is conveyed to the AND-gate 148 through the AND-gate 154 and the OR-gate 147. The counter 142 continues to count. The phase of initial bit allocation is thus maintained until the count 0 (decimal) is reached. The output of the counter 142 now briefly rises. This entails that flip-flop 141 is set through the AND-gate 155. Through the AND-gate 156 and the OR-gate 152 the high output signal of the flip-flop 141 is applied to the set input of the counter 142, which immediately afterwards jumps to count 5 (decimal). In addition, the further down-counting of the counter 142 is blocked because the inverter 153 applies a "low" signal to the one input of the AND-gate 154. From instant $t_6$ onwards there is no bit allocation whatsoever to the relevant subband.

Fig. 12b represents the situation in which $v_i(t)$ has remained in the range between $v_{thr}$ and $w_i(t)$ sufficiently long so that the phase of "no initial bit allocation" has commenced. At the instant $t_7$, $v_i$ will be smaller than $V_{thr}$. At that moment the output 145 will become "low" and the output 146 "high".

At that moment the flip-flop 141 is set through the AND-gate 155 and the counter 142 is reset to the count 5 through the AND-gate 156 and the OR-gate 152. The output of the counter 142 thus becomes "low" and the output of the flip-flop 141 "high". There is no bit allocation.

Fig. 13 shows a situation in which $v_i(t)$ increases again. At the instant $t_8$, $v_i(t)$ becomes larger than $V_{thr}$.

The output 145 becomes "high" so that the counter 142 may count down. One time interval later $v_i(t)$ is again smaller than $v_{thr}$. The output 146 becomes "high" again so that the counter is reset to the count of 5 through the AND-gate 156 and the OR-gate 152. If $v_i(t)$ is greater than $v_{thr}$ for a sufficientiy long period of time, the counter 142 can count down to zero. At $t=t_8$, the output of counter 142 becomes "high". Through the AND-gate 159, to which a "high" signal is applied through the inverter 158, the flip-flop 141 is reset, so that at this moment the phase of "no bit allocation" is terminated and changed into the phase of "no initial bit allocation".

In the following a simplified calculation of the bit need $b_m$ will be explained. In this calculation a logarithmic representation is used for the various magnitudes which play a part in the calculation. This is possible because not absolute but relative precision of the bit needs is concerned with respect to the calculation of the bit needs $b_1$ to $b_M$.

In logarithmic representation a number g is approximated by $g=r^k$, where r is a fixed base greater than unity and the power k is selected to be an integer. The number g is approximated in the best possible way by a right choice of k. The integer k is used as a representation of g. In the calculation for the bit need $b_m$ there are both multiplications of two numbers and additions of two numbers. Multiplications in the logarithmic representation correspond with the addition of the powers. That is to say, if $g_1=r^{k_1}$ and $g_2=r^{k_2}$, the logarithmic representation of $g_1.g_2$ will be equal to $k_1+k_2$.

For the logarithmic representation of additions of these two numbers $g_1$ and $g_2$, the following holds. Assuming that $g_1>g_2$, it holds that $g_1+g_2 = r^{k_1} + T(k_1-k_2)$. The logarithmic representation for $g_1+g_2$ is thus equal to $k_1 + T(k_1-k_2)$. $T(k_1-k_2)$ is a correction factor in the form of an integer which may be derived from a Table. Fig. 7 shows a Table of this type for $r=2^{1/16}$. The value for r equalling $2^{1/16}$ can be obtained from an accuracy analysis of the bit needs $b_m$.

It may further be inferred that the calculation of the needs $b_m$ in a logarithmic representation with a properly selected base r, in lieu of the customary calculations in a linear fixed-point representation, considerably reduces the word widths of the numbers. In addition, no multiplier-accumulator is necessary for calculating the vector {w}, but only a simple accumulator and a Table having a restricted number of entries. The Table of Fig. 7, for example, narrows down to a ROM having contents smaller than 0.5 kbit. The series of numbers stored in the ROM is relatively small. In addition, these numbers are arranged in a specific order. Therefore, it is possible to reduce the look-up Table even more at the cost of some logic.

It should be observed in this context that the logarithmic representation for the addition of two numbers as described hereinbefore is known per se by the name of Zech logarithm and described in document (6), compare, more specifically, chapter 3, section 4, page 191.

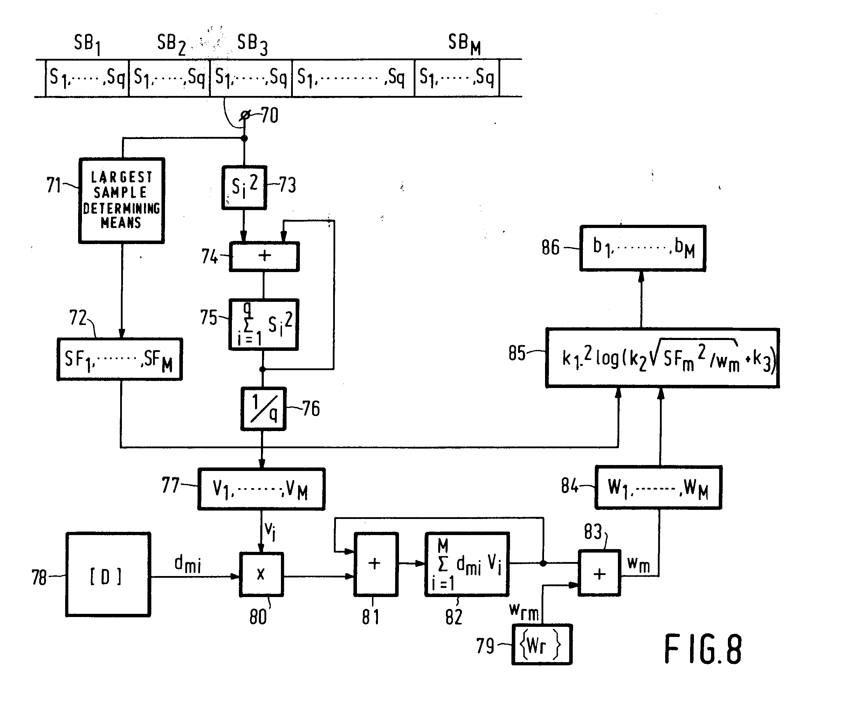

The bit need determining means 6 and the bit allocation means 7 may be arranged in software. However, hardware designs are also possible. For example, Fig. 8 shows a hardware design of the bit need determining means 6.

Fig. 8 shows the corresponding signal blocks in the subband signals $SB_1$ to $SB_M$, which are serially applied to input 70. The first sample $S_1$ of the subband $SB_1$ is applied first and the last sample $S_q$ of the subband $SB_M$ is applied last.

In the largest sample determining means 71 the largest sample $SF_m$ is determined for each signal block, which value is then stored in a memory 72. In a squaring unit 73 the samples are squared and thereafter applied to an input of an adder 74. The output of the adder 74 is coupled to an input of a memory 75. The output of that memory 75 is coupled both to a second input of the adder 74 and an input of a divider 76. The elements referenced 74, 75 and 76 determine the magnitude $v_m$ for each signal block, compare block 16 in Fig. 4. To this end, the first sample $s_1$ of a signal block 3 is squared into the subband signal $SB_m$ in the squaring unit 73 and, in adder 74, added to the value stored in memory 75, which value is momentarily zero, and thereafter stored in the memory 75. Subsequently, the second sample $s_2$ is squared, added to the value stored in memory 75 and then stored in that memory. This is continued until the last sample $s_q$ is squared and added to the value stored in memory 75. The sum thus obtained in the memory 75 is equal to

$$\sum_{i=1}^{q} s_i^2$$

which then, after a division by q in the divider 76, is stored as a coefficient $v_m$ in memory 77. Similar calculations are made for the corresponding signal blocks of the further subbands until all coefficients of the vector {v} have been stored in the memory 77. The bit need determining means 6 further include a memory 78 for storing the matrix coefficient $d_{m1}$ of the matrix [D] and a memory 79 for storing the coefficients $w_{r.m}$ of the vector {$w_r$}. Outputs of the memories 77 and 78 are coupled to inputs of the multiplier 80. An output of the multiplier 80 is coupled to a first input of an adder 81 whose one output is coupled to the input of a memory 82. The output of the memory 82 is coupled both to a second input of the adder 81 and to a first input of an adder 83.

The elements referenced 80, 81 and 82 are intended to perform the matrix multiplication [D]{v}.

During this operation the value $d_{m1}$ from memory

78 is multiplied by the value $v_1$ from memory 77 for a specific subband m and the result is added by adder 81 to the value present in memory 82 at that moment, which is zero, and then stored in memory 82. After this, $d_{m2}$ is multiplied by $v_2$ and the result is added to the value stored in memory 82. This is continued until $d_{mM}$ is multiplied by $v_M$ and the result is added to the value stored in memory 82. At that moment the value

$$\sum_{i=1}^{M} d_{mi} \, v_i$$

is stored in memory 82. In adder 83, the value $w_{r.m}$ stored in memory 79 is added to this result. The value $w_m$ thus obtained is stored in memory 84. This procedure is reiterated for the corresponding signal blocks in the further subbands until all coefficients of the vector $\{w\}$ are stored in memory 84.

Subsequently, for each subband $SB_m$, the magnitudes $SF_m$ and $w_M$ are read from the memories 72 and 84 and applied to the calculation unit which eventually determines the bit need $b_m$. This bit need is stored in a memory 86. This calculation is also performed for the further subbands until all bit needs $b_1$ to $b_M$ are stored in the memory 86.

The procedure may be reiterated for a successive series of M signal blocks. Also the arrangement shown in Fig. 8 utilises the fact that there is serial information supply. If the signal blocks were supplied in parallel, the calculation could largely be performed in parallel. This means, for example, that the circuit comprising the elements 71,73,74,75 and 76 could occur M times in the arrangement. The circuit comprising elements 80, 81, 82 and 83 could then likewise occur M times.

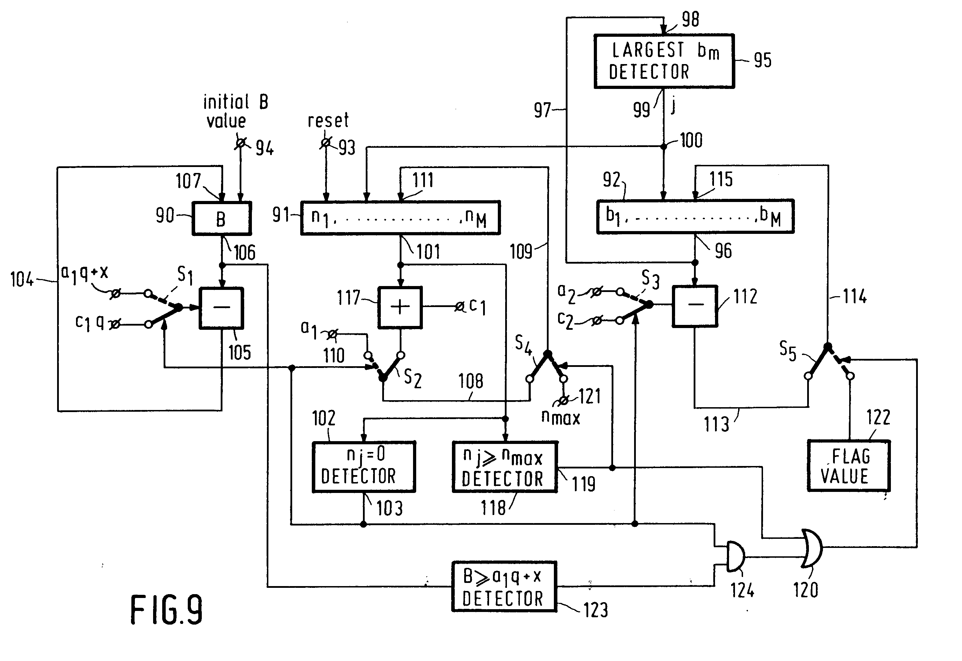

Fig. 9 shows a hardware embodiment of the bit allocation means 7. The bit allocation means comprises a memory 90 in which the number of bits B still to be allocated have been stored, a memory 91 in which the values $n_1$ to $n_M$ are stored and a memory 92 in which the bit needs $b_1$ to $b_M$ have been stored. This memory 92 could correspond with memory 86 of Fig. 8. At the beginning of an allocation cycle the initial value for B is stored in memory 90, which value is available at terminal 94. Furthermore, the initial values for the bit needs $b_m$ have been stored in memory 92 whereas memory 91 stores all zeros fed to terminal 93 by means of reset signals.

Subsequently, detector 95 determines the maximum value of the bit needs stored in memory 92. This may, for example, be realised by successively reading out all bit needs $b_1$ to $b_M$ at the output 96 and applying these bit needs through line 97 to the input 98 of the detector 95. At the output 99, the detector 95 provides the index of the maximum bit need $b_j$. This

index j is used as an address for addressing through line 100 the locations in the memories 91 and 92 in which the values are stored for $n_j$, $b_j$ respectively, so that these values are available at the respective outputs 101 and 96. Output 101 is coupled to an input of an $n_j$=0 detector 102. If the detector 102 detects $n_j$=0, it provides at output 103 a control signal which is applied to control signal inputs of controllable switches $S_1$, $S_2$ and $S_3$. These switches then assume different positions from the ones shown in the drawing Figure. This implies that in a subtractor 105 the value $a_1.q+k$ is subtracted from the value B available at output 106 of memory 90, and this new value is again applied to input 107 of this memory through line 104 so that the new value is stored in memory 90. Furthermore, through lines 108 and 109 the value $a_1$ which is available at terminal 110, is applied to the input 111 of memory 91. Switch $S_4$ then has the position shown in the drawing Figure. This value $a_1$ is stored in memory 91 as a new value for $n_j$. In the subtractor 112 the value $a_2$ is subtracted from the value $b_j$ available at the output 96 of memory 92. The value thus obtained is applied to input 115 through lines 113 and 114, while the switch $S_5$ has the position shown in the drawing Figure, so that the new value for $b_j$ can be stored in the memory location $b_j$ in memory 92.

The method described hereinbefore is the method as denoted in block 54 in Fig. 5.

If the detector 102 detects that $n_j$ is unequal to zero, no (or a different) control signal is generated. Switches $S_1$, $S_2$ and $S_3$ then have the positions shown in the Figure. The value $c_1q$ is now subtracted from the value B stored in memory 90 and the result thus obtained is stored again in memory 90. In the adder 117 the value $c_1$ is added to the value $n_j$ which is read from the memory 91 through output 101. Again through lines 108 and 109 the new value for $n_j$ is applied to input 111 of memory 91 to be stored in the memory 91.

Furthermore, in subtractor 112 the value $c_2$ is subtracted from the value $b_j$ present at the output 91, and the value thus obtained is applied to input 115 through lines 113 and 114 in order to be stored in memory 92. The method described actually corresponds with block 56 of the method shown in Fig. 5.

In the method of Fig. 5 there is further shown that the decision block 48, $n_j \geq n_{max}$?, provides that $b_j$ is made equal to the flag value (block 66 in Fig. 5), and $n_j$ equal to $n_{max}$ (should it turn out to be necessary). In the circuit of Fig. 9 this has been taken into account by means of the $n_j \geq n_{max}$ detector 118. If detector 118 detects a situation in which $n_j \geq n_{max}$, it generates at its output 119 a control signal which is applied to the control input of the controllable switch $S_4$ and, through an OR-gate 120, to the control input of the controllable switch $S_5$, which switches then assumes the positions different from the ones shown in the Figure. The value $n_{max}$, applied to the terminal 121, is now applied to the input 111 of memory 91. $n_{max}$ is then stored in the memory location for $n_j$ in memory 91. Accordingly, the flag value, block 122, is applied to input 115 so that the flag value is stored in the memory location for $b_j$ in memory 92.

It will be evident that there is a central control unit (not shown) which detects the output signal of detector 118 and, on detection of this signal, applies only load pulses to the memories 91 and 92 for storing there $n_{max}$ and the flag value. No load pulse is then applied to memory 90, since the value B in the memory is to remain unchanged.

Furthermore, the flag value is allocated to $b_j$ if both $n_j$ is equal to zero and $B \geqq a_1.q+x$, compare the blocks 50, 52 and 66 in Fig. 5. Thereto the circuit of Fig. 9 includes the detector 123 and the AND-gate 124. At the occurrence of detection signals of both detector 103 and detector 123, switch $S_5$ is again set to the other position than the position shown and the flag value $b_F$ is stored in memory 92 in location j. In this case the central processor will generate a load pulse only for memory 92 and no load pulses for memories 90 and 91.

It will be self-evident that the initial bit allocation as described with reference to Fig. 6 may also be implemented here, for example, controlled by the necessary control and address signals from the central controller. This will not be explained any further because after the above explanation it may be assumed to be within the grasp of those skilled in the art.

Fig. 10 shows the use of the subband coder as described hereinbefore, in a transmitter, especially a transmitter in the form of a recording arrangement for recording the quantized subband signals in one or more tracks on a magnetic record carrier.

The section referenced 130 is the subband coder discussed hereinbefore, which produces the quantized subband signals at the outputs 4.1 to 4.M.

The section referenced 131 converts these signals into a second digital signal which is available at output 132. This second digital signal comprises successive frames of which the format is extensively discussed in the prior-art documents (2a) and (2b). Also the structure of the block 131 is explained in these documents.

The section referenced 133 renders the second digital signal suitable for recording on a record carrier, for example, a magnetic record carrier 134. The unit 133 thereto comprises an 8-to-10 converter. In a converter of this type 8-bit data words in the serial information stream are converted to 10-bit code words. Furthermore, interleaving may take place. All this has for its object to enable error correction of the received information on the receiver side (when reproducing the record carrier).

The output signal of block 133 is applied to recording means 135 by which the signal is recorded in one or more longitudinal tracks on the record carrier 134. The recording means 135 thereto comprise one or more recording heads 136.

For a further explanation of the arrangement of Fig. 10, the prior-art document (8) be referred to, which is also assumed to be incorporated where necessary in this Patent Application.

It should further be observed that the invention is not restricted to the depicted exemplary embodiments only. Various modifications of the embodiments described are feasible without leaving the scope of the invention as defined in the claims.

In the foregoing the bit need determination and bit allocation have been described for a number of M subband signals, while there was always a single subband signal (for example, a mono signal) in each subband.

However, the invention may also be applied to a subband coder for subband encoding of a stereo signal. This implies that there are two subband signals in each subband, that is to say, a left and a right subband signal.

Two optional ways of subband encoding of a stereo signal will be briefly discussed hereinbelow. A first option is to process the left and right subband signals separately in the manner described above. The M subband signals $SB_1$ to $SB_M$ as discussed above are then, for example, the M left subband signals. The procedure discussed hereinbefore is then carried out for these left subband signals. In the bit need determining means 6 first the bit needs $b_{11}$ to $b_{M1}$ are determined. Thereafter, the numbers of bits to be allocated, i.e. $n_{11}$ to $n_{M1}$, are determined in the bit allocation means 7. In the procedure discussed above and explained with reference to Fig. 5, the value B was used for the bit allocation. B was then equal to the number of available bits. It may be obvious that in the present case just half this number of available bits B is used for determining $n_{11}$ to $n_{M1}$. The other half of the number of available bits will then be used for bit allocation to the right subband signals.

The arrangement for the stereo signal subband encoding according to the first option actually comprises twice the arrangement shown in Fig. 1. The second section of the arrangement thus comprises a subband splitter, such as the splitter 2, for generating the M right subband signals. Furthermore, a bit need determining means is present, such as unit 6, which determines the bit needs $b_{1r}$ to $b_{Mr}$, and a bit allocation means, such as unit 7, which derives therefrom the numbers of allocated bits $n_{1r}$ to $n_{Mr}$. Also for this purpose, half the actual number of available bits is available.

According to a second option for subband encoding of a stereo signal the bit needs $b_{11}$ to $b_{M1}$ and $b_{1r}$ to $b_{Mr}$ are derived in the same manner as in the first option. In contradistinction to the first option, in which the bit allocation for the left and right subband signals was performed separately, in the second option the

2M bit needs $b_{11}$ to $b_{M1}$ and $b_{1r}$ to $b_{Mr}$ are applied to a bit allocation unit such as unit 7, which then naturally has 2M inputs. In this unit the 2M numbers $n_{11}$ and $n_{M1}$ and $n_{1r}$ to $n_{Mr}$ are derived in a manner similar to the manner described with reference to Fig. 5 on the basis of the actually available number of bits. For this purpose the bit allocation means have 2M outputs.

It should further be observed that when a stereo signal is encoded, 2M values for the bit allocation information are concerned, represented each by y bits. This means that for the bit allocation procedure for a stereo signal no more than $B=B_0-2.y.M$ bits are available.

PRIOR ART:

(1) European Patent Application No. 289.080 (PHN 12.108)
(2a) Dutch Patent Application No. 89.01.401 (PHN 12.967)
(2b) Dutch Patent Application No. 90.00.338 (PHN 13.241)
(3) EBU Techn. Review, No. 230, August 1988 G. Theile et al. "Low bit rate coding of high-quality audio signal. An introduction to the MASCAM system".
(4) Philips Journal of Research 44,329-343, 1989 R.N.J. Veldhuis et al. "Subband coding of digital audio signals".
(5) IEEE ICASSP 80, Vol. 1, pp. 327-331, April 9-11, 1980 M.A. Krasner "The critical band coder - - Digital encoding of speech signals based on the perceptual requirements of the auditory system".
(6) F.J. MacWilliams et al., "The theory of error correcting codes", North Holland publishing comp. 1983
(7) European Patent Application No. 89201408.5 (PHQ 89.018)
(8) Dutch Patent Application No. 90.00.635 (PHN 13.281)

**Claims**

1. Encoding system, comprising a subband coder for subband coding of a wideband digital signal, for example, a digital audio signal, at a specific sampling frequency $F_s$, the subband coder including signal splitting means for generating, in response to the wideband digital signal, a plurality of P subband signals with sampling frequency reduction, for which purpose the splitting means split up the wideband digital signal into M successive subbands $(SB_1...SB_M)$ which augment with frequency, which encoding system further comprises quantizing means $(Q_1...Q_M, 6, 7)$ for quantizing block-by-block the respective subband signals, a quantized subband signal m being composed of successive signal blocks, each signal block comprising q samples, the q samples in a signal block of the subband signal m being represented each by $n_m$ bits, the quantizing means including bit need determining means (6) for determining a bit need $b_m$ per signal block for corresponding signal blocks in the subband signals, which bit need is related to the number of bits by which samples in a signal block in the subband signal m should be represented, and the quantizing means $(Q_1...Q_M, 6, 7)$ including a bit allocation means (7) for allocating an available quantity of bits B to corresponding signals blocks of the various subband signals in response to the bit need determined by the bit need determining means (6) so as to obtain the values $n_m$, where m ranges from 1 to P, and which encoding system further comprises accommodating means for accommodating the samples quantized with a certain number of bits in a signal block in a frame of a second digital signal having successive frames, the accommodating means further being arranged for accommodating the scale factor information in a frame, which scale factor information comprises x-bit words, an x-bit word representing a scale factor associated to the samples in a signal block, characterised in that on the basis of the bit needs, for corresponding signal blocks in the subband signals in the subbands determined in the bit need determining means, the bit allocation means (7) is arranged for the following operations in a specific step $S_1$:

(a) determining $b_j$, which is the largest of the bit needs,
(b) establishing whether bits have previously been allocated to the signal block belonging to the bit need $b_j$, and if they have not, then
(c)
- allocating a value $a_1$ to $n_j$;
- subtracting a value $a_2$ from $b_j$;
- subtracting the value $a_1.q+x$ from B,
and if they have, then
(d)
- adding the value $c_1$ to $n_j$;
- subtracting the value $c_2$ from $b_j$;
- subtracting the value $c_1.q$ from B,
and for performing the step $S_1$ at least a second time, in that q and x are integers greater than unity, in that $n_m$ and $b_m$ are variables where $n_m$ is greater than or equal to zero, $a_1$, $a_2$, $c_1$ and $c_2$ are numbers greater than zero and B is an integer greater than zero, m is a variable integer, $a_1$ is greater than $c_1$ and $a_2$ is greater than or equal to $c_2$.

2. Encoding system as claimed in Claim 1, characterized in that the bit allocation means is arranged for carrying out the following operations in a step

$S_0$ prior to the steps $S_1$, for a signal block k in a subband

- allocating a value $A_{k0}$ to $n_k$;
- subtracting the value $A_{k1}$ from $b_k$;
- subtracting the value $A_{k0}.q+x$ from B, and in that $A_{k0}$ and $A_{k1}$ are numbers greater than zero.

3. Encoding system as claimed in Claim 2, characterized in that the bit allocation means is arranged for allocating a flag value in the step $S_0$ to a signal block in one or more of the subbands, which flag value indicates that no bits are to be allocated to the signal block concerned.

4. Encoding system as claimed in Claim 2 or 3, characterized in that $A_{k0}$ is equal to $a_1$ and $A_{k1}$ is equal to $a_2$.

5. Encoding system as claimed in one of the preceding Claims, characterized in that $a_1$ is equal to $a_2$ and $c_1$ is equal to $c_2$.

6. Encoding system as claimed in one of the preceding Claims for subband encoding of a single digital signal, such as a mono signal or a left or right signal portion of a stereo signal, characterized in that P = M.

7. Encoding system as claimed in one of the Claims 1 to 5 for subband encoding of a stereo signal, comprising a left and a right signal portion, characterized in that P = 2M.

8. Transmitter comprising the encoding system as claimed in one of the preceding Claims 1 to 7.

9. Transmitter as claimed in Claim 8, characterized in that the transmitter has the form of an arrangement for recording the quantized subband signals in a track on a record carrier.

10. Transmitter as claimed in Claim 9, characterized in that the record carrier is a magnetic record carrier.

**Patentansprüche**

1. Codieranordnung mit einem Unterbandcoder zum Unterbandcodieren eines digitalen Breitbandsignals, beispielsweise eines digitalen Audiosignals, mit einer bestimmten Abtastrate $F_s$, wobei der Unterbandcoder mit Signalspaltmitteln versehen ist zum in Antwort auf das digitale Breitbandsignal Erzeugen einer Anzahl von P Unterbandsignalen mit Abtastratenverringerung, wozu die Spaltmittel das digitale Breitbandsignal in M

aufeinanderfolgenden Unterbänder ($SB_1...SB_m$) mit Bandnummern m aufteilen, die mit der Frequenz zunehmen, wobei die Codieranordnung weiterhin Quantisiermittel ($Q_1, ...Q_M$, 6, 7) aufweist zum blockweisen Quantisieren der betreffenden Unterbandsignale, wobei ein quantisiertes Unterbandsignal m aus aufeinanderfolgenden Signalblöcken aufgebaut ist, wobei jeder Signalblock in einem Unterband q Abtastwerte aufweist, wobei die q Abtastwerte in einem Signalblock mit je $n_m$ Bits dargestellt sind, wobei die Quantisiermittel Bitbedarfbestimmungsmittel aufweisen zum für entsprechende Signalblöcke in den Unterbändern je Signalblock Bestimmen eines Bitbedarfs $b_m$, der in einem Verhältnis zu der Anzahl Bits steht, mit der Abtastwerte in einem Signalblock in dem Unterband $SB_m$ dargestellt werden müßten und mit Bitzuordnungsmitteln zum Zuordnen der verfügbaren Bitmenge B zu den jeweiligen Unterbändern, je nach dem Bitbedarf, wie dieser durch die Bitbedarfbestimmungsmittel bestimmt worden ist zum Erhalten der Werte $n_m$, wobei m von 1 bis einschließlich P geht, wobei die Codieranordnung weiterhin Mittel aufweist zum Unterbringen der mit einer bestimmten Menge Bits quantisierten Abtastwerte in einem Signalblock in einem Rahmen eines zweiten digitalen Signals mit aufeinanderfolgenden Rahmen, wobei die Mittel weiterhin dazu eingerichtet sind, in einem Rahmen Unterbringen von Skalenfaktorinformation, wobei die Skalenfaktorinformation x-Bits-Worte aufweisen, wobei ein x-Bit-Wort einen den Abtastwerten in einem Signalblock zugeordneten Skalenfaktor darstellt, <u>dadurch gekennzeichnet,</u> daß ausgehend von dem Bitbedarf, für entsprechende Signalblöcke in den Unterbandsignalen in den Unterbändern, ermittelt in den Bitbedarfbestimmungsmitteln, die Bitzuordnungsmittel (7) für die nachfolgenden Vorgänge in einem bestimmten Verfahrensschritt $S_1$ eingerichtet sind:

(a) Bestimmung von $b_j$, d.h. dem größten Bitbedarf,

(b) Ermittlung, ob dem dem Bitbedarf bj zugeordneten Signalblock bereits Bits zugeordnet worden sind, und wenn nicht, dann:

(c)
- Zuordnung eines Werte $a_1$ bis $n_j$;
- Subtraktion eines Wertes $a_2$ von $b_j$;
- Sbtraktion des Wertes $a_j.q+x$ von B, und wenn ja, dann:

(d)
- Addierung des Wertes $c_1$ zu $n_j$;
- Subtraktion des Wertes $c_2$ von $b_j$;
- Subtraktion des Wertes $c_1.q$ von B, und zum wenigstens einmal Wiederholen des Verfahrensschrittes $S_1$, wobei dann q und x ganze Zahlen über eins sind, daß $n_m$ und

$b_m$ veränderliche Zahlen sind, wobei $n_m$ größer als oder gleich Null ist, $a_1$, $a_2$, $c_1$ und $c_2$ Zahlen größer als Null sind und B eine ganze Zahl größer als Null ist, m eine veränderliche ganze Zahl ist, $a_1$ größer ist als $c_1$ und $a_2$ größer als oder gleich $c_2$ ist.

2. Codieranordnung nach Anspruch 1, <u>dadurch gekennzeichnet</u>, daß die Bitzuordnungsmittel dazu eingerichtet sind, in einem Schritt $S_0$ vor den Schritten $s_1$ für einen Signalblock eines oder mehrerer Unterbänder $SB_k$ folgendes durchzuführen:
   - Zuordnung eines Wertes $A_{k0}$ bis $n_k$;
   - Subtraktion der Werte $A_{k1}$ von $b_k$;
   - Subtraktion des Wertes $A_{k0}.q+x$ von B, und daß $A_{k0}$ und $A_{k1}$ Zahlen größer als Null sind.

3. Codieranordnung nach Anspruch 2, <u>dadurch gekennzeichnet</u>, daß die Bitzuordnungsmittel dazu eingerichtet sind, in dem Schritt $S_0$ für einen Signalblock einer oder mehrerer der Unterbänder einen Flaggenwert zuzuordnen, der angibt, daß dem betreffenden Signalblock keine Bits zugeordnet werden müssen.

4. Codieranordnung nach Anspruch 2 oder 3, <u>dadurch gekennzeichnet</u>, daß $A_{k0}$ gleich $a_1$ und $\overline{A_{k1}}$ gleich $a_2$ ist.

5. Codieranordnung nach einem der vorstehenden Ansprüche, <u>dadurch gekennzeichnet</u>, daß $a_1$ gleich $a_2$ und $c_1$ gleich $c_2$ ist.

6. Codieranordnung nach einem der vorstehenden Ansprüche zur Unterbandcodierung eines einfachen digitalen Signalen, wie eines Mono-Signals oder eines linken oder rechten Signalteisl eines Stereo-Signals, <u>dadurch gekennzeichnet</u>, daß P = M ist.

7. Codieranordnung nach einem der Ansprüche 1 bis 5 zur Unterbandcodierung eines Stereo-Signals mit einem linken und einem rechten Signalteil, <u>dadurch gekennzeichnet</u>, daß P = 2M ist.

8. Sender mit der Codieranordnung nach einem vorstehenden Ansprüche 1 bis 7.

9. Sender nach Anspruch 8, <u>dadurch gekennzeichnet</u>, daß der Sender die Form einer Anordnung zum Aufzeichnen der quantisierten Unterbandsignale in einer Spur auf einem Aufzeichnungsträger hat.

10. Sender nach Anspruch 9, <u>dadurch gekennzeichnet</u>, daß der Aufzeichnungsträger ein magnetischer Aufzeichnungsträger ist.

## Revendications

1. Système de codage comprenant un codeur de sous-bandes pour codage en sous-bandes d'un signal numérique à large bande, par exemple un signal audionumérique, à une fréquence d'échantillonnage spécifique $F_s$, le codeur de sous-bandes comprenant des moyens de division de signaux pour générer, en réaction au signal numérique à large bande, une pluralité de P signaux de sous-bandes avec une réduction de la fréquence d'échantillonnage, les moyens de division divisant à cet effet le signal numérique à large bande en M sous-bandes successives ($SB_1$, ..., $SB_M$) qui augmentent avec la fréquence, ledit système de codage comprenant, en outre, des moyens de quantification ($Q_1$, ..., $Q_M$, 6, 7) pour quantifier bloc par bloc les signaux de sous-bandes respectifs, un signal de sous-bande quantifié m étant constitué de blocs de signaux successifs, chaque bloc de signal comprenant q échantillons, les q échantillons d'un bloc de signal du signal de sous-bande m étant représentés chacun par $n_m$ bits, les moyens de quantification comprenant des moyens de détermination des besoins en bits (6) pour déterminer un besoin en bits $b_m$ par bloc de signal pour des blocs de signaux correspondants dans les signaux de sous-bandes, ledit besoin en bits étant en rapport avec le nombre de bits par lequel des échantillons dans un bloc de signal du signal de sous-bande m doivent être représentés, et les moyens de quantification ($Q_1$, ..., $Q_M$, 6, 7) comprenant des moyens d'affectation de bits (7) destinés à affecter une quantité disponible de bits B aux blocs de signaux correspondants des divers signaux de sous-bandes en réaction au besoin en bits déterminé par les moyens de détermination des besoins en bits (6) de manière à obtenir des valeur $n_m$, où m se situe dans une plage de 1 à P, ledit système de codage comprenant, en outre, des moyens d'accueil pour recevoir les échantillons quantifiés avec un certain nombre de bits dans un bloc de signal dans une trame d'un deuxième signal numérique ayant des trames successives, les moyens d'accueil étant, en outre, à même de recevoir les informations de facteur d'échelle dans une trame, ces informations de facteur d'échelle comprenant des mots de x bits, un mot de x bits représentant un facteur d'échelle associé aux échantillons dans un bloc de signal, caractérisé en ce que, sur la base des besoins en bits, pour des blocs de signaux correspondants dans les signaux de sous-bandes dans les sous-bandes déterminées dans les moyens de détermination des besoins en bits, les moyens d'affectation de bits (7) sont agencés pour exécuter les opérations suivantes dans une étape spécifique $S_1$ :

(a) déterminer $b_j$, qui est le plus grand des besoins en bits;

(b) établir si des bits ont été précédemment affectés au bloc de signal appartenant au besoin en bits $b_j$ et, dans la négative,

(c)
- affecter une valeur $a_1$ à $n_j$;
- soustraire une valeur $a_2$ de $b_j$;
- soustraire la valeur $a_1.q+x$ de B, et dans l'affirmative,

(d)
- ajouter la valeur $c_1$ à $n_j$;
- soustraire la valeur $c_2$ de $b_j$;
- soustraire la valeur $c_1.q$ de B, et

pour exécuter l'étape $S_1$ au moins une seconde fois, en ce que q et x sont des nombres entiers supérieurs à l'unité, en ce que $n_m$ et $b_m$ sont des variables où $n_m$ est supérieure ou égal à zéro, $a_1$, $a_2$, $c_1$ et $c_2$ sont des nombres supérieurs à zéro et B est un nombre entier supérieur à zéro, m est un nombre entier variable, a1 est supérieur à c1 et $a_2$ est supérieur ou égal à $c_2$.

2. Système de codage suivant la revendication 1, caractérisé en ce que les moyens d'affectation des bits sont agencés pour exécuter les opérations suivantes dans une étape $S_0$ précédant les étapes S1, pour un bloc de signal k dans une sous-bande :
- affecter une valeur $A_{k0}$ à $n_k$;
- soustraire la valeur $A_{k1}$ de $b_k$;
- soustraire la valeur $A_{k0}.q+x$ de B, et en ce que $A_{k0}$ et $A_{k1}$ sont des nombres supérieurs à zéro.

3. Système de codage suivant la revendication 2, caractérisé en ce que les moyens d'affectation de bits sont prévus pour affecter une valeur indicatrice dans l'étape $S_0$ à un bloc de signal dans une ou plusieurs des sous-bandes, cette valeur indicatrice indiquant qu'aucun bit ne doit être affecté au bloc de signal en question.

4. Système de codage suivant la revendication 2 ou 3, caractérisé en ce que $A_{k0}$ est égal à $a_1$ et $A_{k1}$ est égal à $a_2$.

5. Système de codage suivant l'une quelconque des revendications précédentes caractérisé en ce que a1 est égal à $a_2$ et $c_1$ est égal à $c_2$.

6. Système de codage suivant l'une quelconque des revendications précédentes pour le codage en sous-bandes d'un signal numérique simple tel qu'un signal mono ou une partie de signal gauche ou droit d'un signal stéréo, caractérisé en ce que P = M.

7. Système de codage suivant l'une quelconque des revendications 1 à 5, pour le codage en sous-bandes d'un signal stéréo comprenant une partie de signal gauche et une partie droite, caractérisé en ce que P = 2M.

8. Emetteur comprenant le système de codage suivant l'une quelconque des revendications 1 à 7.

9. Emetteur suivant la revendication 8, caractérisé en ce qu'il se présente sous la forme d'un dispositif pour l'enregistrement des signaux de sous-bandes quantifiés dans une piste sur un support d'enregistrement.

10. Emetteur suivant la revendication 9, caractérisé en ce que le support d'enregistrement est un support d'enregistrement magnétique.

FIG.1

FIG.1a

**FIG.2**

**FIG.3**

FIG.4

START —40

$n_m = 0$
FOR m = 1,....,M —42

INITIAL
ALLOCATION —44

DETERMINE
LARGEST $b_m = (b_j)$ —46

48
$n_j \geqslant n_{max}$?

50
$n_j = 0$?

52
$B \geqslant a_1 q \cdot x$?

64

$b_j = FLAGVALUE$ —66

$n_j = a_1$
$b_j = b_j - a_2$ —54
$B = B - a_1 q \cdot x$

56
$n_j = n_j + C_1$
$b_j = b_j - C_2$
$B = B - C_1 q$

58
any $b_m >$ FLAGVALUE ?

60
$B < C_1 q$?

62

STOP —68

FIG.5

18

44

| $n_k = A_{k0}$ $b_k = b_k - A_{k1}$ $B = B - A_{k0} q - x$ | $n_l = A_{l0}$ $b_l = b_l - A_{l1}$ $B = B - A_{l0} q - x$ | - - - - | $b_f = \text{FLAGVALUE}$ | - - - - |
|---|---|---|---|---|

## FIG.6

| $k_1 - k_2$ | $T(\cdots)$ | $k_1 - k_2$ | $T(\cdots)$ | $k_1 - k_2$ | $T(\cdots)$ | $k_1 - k_2$ | $T(\cdots)$ | $k_1 - k_2$ | $T(\cdots)$ | $k_1 - k_2$ | $T(\cdots)$ |
|---|---|---|---|---|---|---|---|---|---|---|---|
| 0 | 16 | 15 | 10 | 30 | 6 | 45 | 3 | 60 | 2 | 75 | 1 |
| 1 | 16 | 16 | 9 | 31 | 5 | 46 | 3 | 61 | 2 | 76 | 1 |
| 2 | 15 | 17 | 9 | 32 | 5 | 47 | 3 | 62 | 2 | 77 | 1 |
| 3 | 15 | 18 | 9 | 33 | 5 | 48 | 3 | 63 | 1 | 78 | 1 |
| 4 | 14 | 19 | 8 | 34 | 5 | 49 | 3 | 64 | 1 | 79 | 1 |
| 5 | 14 | 20 | 8 | 35 | 5 | 50 | 3 | 65 | 1 | 80 | 1 |
| 6 | 13 | 21 | 8 | 36 | 4 | 51 | 2 | 66 | 1 | 81 | 1 |
| 7 | 13 | 22 | 8 | 37 | 4 | 52 | 2 | 67 | 1 | 82 | 1 |
| 8 | 12 | 23 | 7 | 38 | 4 | 53 | 2 | 68 | 1 | 83 | 1 |
| 9 | 12 | 24 | 7 | 39 | 4 | 54 | 2 | 69 | 1 | 84 | 1 |
| 10 | 12 | 25 | 7 | 40 | 4 | 55 | 2 | 70 | 1 | 85 | 1 |
| 11 | 11 | 26 | 6 | 41 | 4 | 56 | 2 | 71 | 1 | 86 | 1 |
| 12 | 11 | 27 | 6 | 42 | 3 | 57 | 2 | 72 | 1 | 87 | 1 |
| 13 | 10 | 28 | 6 | 43 | 3 | 58 | 2 | 73 | 1 | 88 | 1 |
| 14 | 10 | 29 | 6 | 44 | 3 | 59 | 2 | 74 | 1 | 89 | 0 |

## FIG.7

EP 0 457 390 B1

$SB_1$ $SB_2$ $SB_3$ $SB_M$

| $S_1,\ldots,S_q$ | $S_1,\ldots,S_q$ | $S_1,\ldots,S_q$ | $S_1,\ldots,S_q$ | $S_1,\ldots,S_q$ |

$\emptyset$ –70

71 — LARGEST SAMPLE DETERMINING MEANS

$S_i{}^2$ –73

86 — $b_1,\ldots,b_M$

74 — $+$

72 — $SF_1,\ldots,SF_M$

75 — $\displaystyle\sum_{i=1}^{q} S_i{}^2$

85 — $k_1{}^2 \log\left(k_2\sqrt{SF_m{}^2/w_m}+k_3\right)$

$\frac{1}{q}$ –76

77 — $V_1,\ldots,V_M$

84 — $W_1,\ldots,W_M$

$v_i$

78 — $[D]$

$d_{mi}$

$\times$ — 80

$+$ — 81

$\displaystyle\sum_{i=1}^{M} d_{mi}\,v_i$ — 82

83

$+$

$w_m$

$w_{rm}$

79 — $\{W_r\}$

FIG.8

FIG.9

FIG.10

FIG.11

FIG.12a

FIG.12 b

FIG.13

FIG.14